(19) **Europäisches Patentamt / European Patent Office / Office européen des brevets**

(11) **EP 3 720 923 B1**

(12) **FASCICULE DE BREVET EUROPEEN**

(45) Date de publication et mention de la délivrance du brevet:
**15.11.2023 Bulletin 2023/46**

(21) Numéro de dépôt: **18836830.2**

(22) Date de dépôt: **04.12.2018**

(51) Classification Internationale des Brevets (IPC):
**C09K 11/02** (2006.01)   **C09K 11/08** (2006.01)

(52) Classification Coopérative des Brevets (CPC):
**C09K 11/02; C09K 11/7774**

(86) Numéro de dépôt international:
**PCT/FR2018/053094**

(87) Numéro de publication internationale:
**WO 2019/110910 (13.06.2019 Gazette 2019/24)**

(54) **SOLUTION DESTINÉE A ÊTRE UTILISÉE POUR REMPLIR DES CAVITÉS DE TAILLE MICROMÉTRIQUE**

LÖSUNG ZUR VERWENDUNG BEIM FÜLLEN VON KAVITÄTEN IN MIKROMETERGRÖSSE

SOLUTION FOR USE IN FILLING MICROMETER-SIZE CAVITIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.12.2017 FR 1761672**

(43) Date de publication de la demande:
**14.10.2020 Bulletin 2020/42**

(73) Titulaire: **COMMISSARIAT À L'ÉNERGIE ATOMIQUE ET AUX ÉNERGIES ALTERNATIVES**
**75015 Paris (FR)**

(72) Inventeurs:
- **LE BLEVENNEC, Gilles**
  **38190 Bernin (FR)**
- **DE SOUSA NOBRE, Sonia**
  **38950 Saint Martin le Vinoux (FR)**
- **PONCELET, Olivier**
  **38000 Grenoble (FR)**

(74) Mandataire: **Brevalex**
**Tour Trinity**
**1 B Place de la Défense**
**92400 Courbevoie (FR)**

(56) Documents cités:
**EP-A1- 2 826 836       WO-A1-2017/180333**
**US-A1- 2017 306 221**

**Description**

La présente invention se rapporte à une solution, destinée à être utilisée pour remplir des cavités de taille micrométrique.

La présente invention concerne également un procédé pour réaliser un matériau composite, comprenant une matrice polymérique dans laquelle sont dispersés des luminophores, dans des cavités de taille micrométrique, à partir d'une telle solution.

L'invention trouve des applications dans le domaine de l'éclairage, par exemple pour les phares de voitures dans l'automobile, ou pour l'habitat, ou encore dans le domaine de l'affichage d'image en général, par exemple pour des lunettes virtuelles ou des écrans basse consommation.

L'évolution des dispositifs d'éclairement ou d'affichage se fait continuellement vers une augmentation des flux lumineux et vers une plus haute définition des surfaces émissives. Par exemple, en ce qui concerne l'éclairage, nous sommes passés de l'ampoule à incandescence aux éclairages avec des diodes électroluminescentes (ou LED, pour « Light-Emitting Diode »). Pour l'affichage, nous sommes passés des tubes cathodiques aux écrans à cristaux liquides, puis aux écrans à diode électroluminescente organique (OLED pour « Organic Light-Emitting Diode »).

La réponse commune à ces deux évolutions parallèles est l'utilisation d'une matrice pixélisée de LED de taille micrométrique (typiquement ayant des dimensions de l'ordre de un micromètre à quelques dizaines de micromètres).

Classiquement, les LED sont réalisées avec du nitrure de gallium (GaN) qui émet à des longueurs d'ondes de l'ordre de 450 nanomètres. Cependant, la lumière bleue est la plus énergétique du spectre visible, et il est donc nécessaire de réaliser une opération de conversion à l'échelle du pixel pour obtenir une lumière blanche ou pour obtenir une longueur d'onde particulière correspondant par exemple à du vert ou à du rouge. Pour obtenir de la lumière blanche, il est possible d'associer le GaN à un élément photoluminescent émettant dans le jaune, couleur complémentaire du bleu. Les deux rayonnements se combinent pour donner une lumière qui apparaît alors comme blanche à l'œil humain. Généralement, il s'agit du YAG:Ce, (pour l'acronyme de l'anglais « Yttrium Aluminium Garnet », qui désigne le « grenat d'yttrium et d'aluminium » dopé au cérium).

Pour réaliser le dispositif de conversion, une solution contenant les particules de YAG:Ce, sous forme de particules de taille submicronique, et un polymère, est déposée dans des cavités de taille micrométrique (typiquement inférieure ou égale à $10\,\mu m$) situées au-dessus des pixels de GaN. Après évaporation du solvant, une couche de conversion comprenant une matrice polymérique dans laquelle sont dispersées des particules de YAG:Ce est obtenue.

Cependant, remplir une cavité d'au plus $10\,\mu m$ de côté avec une solution est un problème techniquement difficile.

En effet, la diminution de la taille des systèmes s'accompagne d'un changement dans la hiérarchie des forces: pour des systèmes mobiles, à l'échelle macroscopique, les forces de pesanteur et les forces inertielles dominent alors qu'à l'échelle microscopique, les forces capillaires et les forces surfaciques les surpassent.

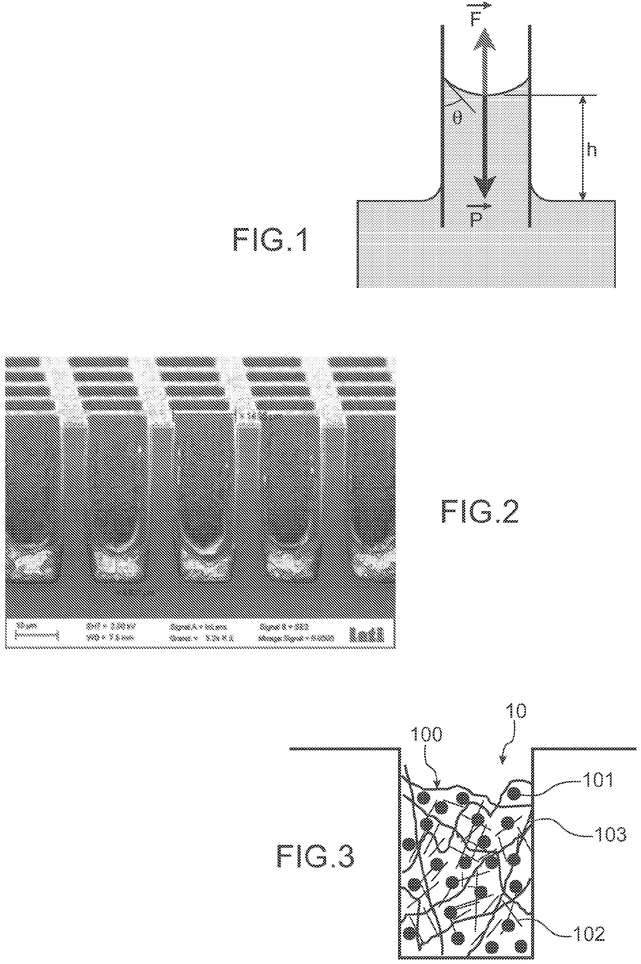

La capillarité est un phénomène d'interaction qui peut se produire aux interfaces entre un liquide et une surface. La capillarité est due aux forces de tension superficielle entre les différentes phases en présence. En raison des forces de capillarité sur les parois des cavités, la surface libre d'un liquide n'est pas horizontale. En référence à la figure 1, la force de tension superficielle F et la hauteur de liquide h sont définies, respectivement, par les équations suivantes dans le cas où la cavité est un tube :

$$F= 2\pi r\,\gamma\,\cos\theta \text{ et } h= 2\,\gamma\,\cos\theta\,/\,r\rho g$$

avec :

    h est la hauteur du liquide dans le tube en m ;
    $\gamma$ est la tension superficielle du liquide en $N.m^{-1}$ ;
    $\theta$ est l'angle de raccordement entre le liquide et la paroi du tube ;
    $\rho$ est la masse volumique du liquide en $g.cm^{-3}$ ;
    r est le rayon du tube en mm ;
    g est l'accélération de la pesanteur, c'est une constante valant environ $9{,}81\ m.s^{-2}$.

D'une manière générale, les interfaces liquides en contact avec des parois solides lyophiles formant un dièdre, présentent une avancée qui tend à se propager dans l'angle sous forme de filament. Cet effet tient au fait que la courbure de l'interface est très fortement diminuée dans l'angle et que la pression de Laplace y est faible, ce qui provoque un mouvement du liquide qui s'avance dans l'angle. Quand l'angle de mouillage dans l'angle est plus petit que la limite dite limite de Conçus et Finn, il se forme un filament. Dans le cas de paroi mouillante, le critère indiquant la formation d'un filament de liquide dans un angle solide s'exprime par : $\theta < \pi/2 - \alpha$.

Avec $\theta$ l'angle de contact de Young (les deux parois sont de même nature), et $\alpha$ le demi-angle du dièdre.

Des parois mouillantes conduisent à une surface de liquide concave alors que des parois non mouillantes produisent une surface convexe. Dans le cas d'une paroi non mouillante, il existe une limite au-delà de laquelle le liquide se détache totalement de l'angle. La condition est définie par $\theta > \pi/2 + \alpha$.

Les cavités des LED sont aujourd'hui réalisées avec des parois métalliques, par exemple en cuivre ou en aluminium. Nous sommes donc en présence d'angles, plus ou moins vifs, droits, aigus ou obtus, et de parois plus ou moins mouillantes. Il est important que le liquide ne puisse pas remonter au-dessus de la paroi séparant deux cavités.

De plus, le remplissage d'une cavité par une solution contenant un solvant et un polymère pose également des problèmes de séchage. En effet, en s'évaporant le solvant va venir déformer l'interface air/solide, ce qui peut créer des porosités dans la matière. Ce phénomène va dépendre principalement de la tension de vapeur de solvant, en proximité des cavités, qui détermine la vitesse d'évaporation du solvant et donc aussi la capacité pour le polymère à s'auto-organiser ou à s'auto-densifier dans la cavité.

En guise d'exemple, la figure 2 montre des microcavités dans lesquelles une solution contenant du YAG:Ce et du poly(méthacrylate de méthyle) (PMMA) a été déposée. En raison des phénomènes de capillarité, le dépôt est principalement localisé sur les parois et ne peut pas réaliser la fonction de conversion souhaitée.

Par exemple, le document WO 2017/180333 A1 décrit un matériau composite comprenant deux polymères ayant des poids moléculaires différents, un des poids moléculaire étant de 10 à 50 fois supérieur à l'autre poids moléculaire, et des luminophores (quantum dots). Le document EP 2 826 836 A1 décrit un matériau composite comprenant deux polymères ayant des poids moléculaires différents, un tensio-actif et des luminophores (quantum dots). Le document US 2017/306221 A1 décrit un procédé de production d'un matériau luminescent composite comprenant des particules d'un matériau inorganique poreux dont les macropores sont au moins partiellement remplis d'un matériau polymère dans lequel est incorporé un matériau luminescent.

## EXPOSÉ DE L'INVENTION

C'est, par conséquent, un but de la présente invention de proposer une solution de luminophore pouvant remplir des cavités de tailles micrométriques (dimensions inférieures à $100\mu m$, et de préférence inférieures à $20\mu m$) tout en évitant les problèmes de capillarité et permettant de laisser une matière solide bien structurée, dans les cavités, après évaporation du solvant.

Le but précédemment énoncé est atteint par une solution, destinée à être utilisée pour remplir des cavités de taille micrométrique, la solution comprenant un premier solvant, un premier polymère d'un premier poids moléculaire, un deuxième polymère d'un deuxième poids moléculaire, des luminophores, et un tensio-actif, le deuxième poids moléculaire étant de 10 à 50 fois supérieur au premier poids moléculaire.

L'invention se distingue fondamentalement de l'art antérieur par la présence de deux polymères, l'un de faible poids moléculaire relativement au deuxième poids moléculaire, et donc ayant de courtes chaines moléculaires, et l'autre de haut poids moléculaire relativement au premier poids moléculaire, et donc ayant de longues chaines moléculaires. La présence des grandes chaînes structurent la matière solide au moment du dépôt et du séchage. Les luminophores et le premier polymère sont entraînés de façon homogène lors du remplissage des cavités. Il n'y a pas de baisse du niveau de remplissage. La présence des grandes chaînes empêchent les petites chaînes et les luminophores de refluer au gré des phénomènes capillaires. Le ménisque d'interface air/solide, dans la cavité, est quasiment horizontal. Lors de l'évaporation du solvant, il n'y a pas d'effondrement de la structure solide finale. Après évaporation du solvant, les cavités sont remplies de manière homogène par un matériau composite comprenant une matrice polymérique dans laquelle sont dispersés les luminophores de manière homogène. La qualité des matériaux composites, ainsi obtenus, permet de réaliser la fonction de conversion lumineuse.

Avantageusement, le deuxième poids moléculaire est environ 20 fois supérieur au premier poids moléculaire.

Avantageusement, le premier et le deuxième polymère sont choisis indépendamment l'un de l'autre parmi un poly(méth)acrylate, un polysiloxane, un polycarbonate, un poly($\varepsilon$-caprolactone), un polystyrène et un de leur copolymère. Ces polymères sont peu réactifs envers les luminophores. Ils présentent, en plus, une bonne stabilité dans le temps et/ou une bonne résistance thermique.

Avantageusement, le premier polymère et/ou le deuxième polymère sont des homopolymères.

Avantageusement, le premier polymère et le deuxième polymère sont de la même nature chimique. Avec des polymères de même nature, le figeage des polymères et le séchage sera plus homogène. Les polymères auront la même affinité chimique, ou des affinités chimiques proches, pour le ou les solvants de la formulation ainsi que pour les luminophores.

Avantageusement, le premier polymère et le deuxième polymère sont des poly(méthacrylate de méthyle). Ce polymère n'affecte pas les propriétés photophysiques (absorption/émission) des luminophores et permet de bien les disperser en solution, ce qui améliore les propriétés de conversion du matériau composite remplissant la cavité.

Avantageusement, la solution comporte un deuxième solvant, dont la température d'ébullition est supérieure d'au moins 30°C à la température du premier solvant. Ceci permet d'éliminer les solvants l'un après l'autre. On choisira, de préférence, un deuxième solvant ayant une bonne affinité envers les polymères et un premier solvant ayant une moins bonne affinité envers les polymères (solvant dit intermédiaire). Le bon solvant, va s'évaporer, en premier après le dépôt. Le solvant intermédiaire va fixer et conserver la structure des polymères, avant d'être lui-même évaporé.

Avantageusement, lorsque le premier polymère et le deuxième polymère sont du PMMA, le premier solvant est la butanone et le deuxième solvant est l'anisole.

Avantageusement, les luminophores sont choisis parmi les phosphores, tels que $SrSi_2O_2N_2$ :$Eu^{2+}$, $\beta$-SiAlON, $Y_3Al_5O_{12}$ :$Ce^{3+}$, $SrSi_5N_8$ :$Eu^{2+}$, $(Ba,Sr)_2Si_5N_8$ : $Eu^{2+}$, (Ca,Sr), $AlSiN_3$ : $Eu^{2+}$, $Sr[LiAlN_4]$ : $Eu^{2+}$, $Sr[Mg_3SiN_4]$ : $Eu^{2+}$, $Sr_{1-x}Ca_x$ S : $Eu^{2+}$, $K_2SiF_6$ :$Mn^{4+}$, et parmi les quantum dots tels que ZnS, ZnSe, CdS, CdSe, CdZnSe, CdTe, PbS, InP, $CuInS_2$, $CuGaS_2$, $CuInSe_2$, $CuGaSe_2$, $CuInGaSe_2$, CuSe, InSe, et GaSe. Ces luminophores ont des propriétés de conversion plus stables dans le temps que des luminophores organiques.

Avantageusement, les luminophores ont une plus grande dimension inférieure à $1\mu m$, et de préférence inférieure à 500nm.

Avantageusement, le rapport solvant/matière sèche va de 40% à 60% massique. Par matière sèche, on entend les polymères, les luminophores et le tensio-actif. Une telle gamme permet d'obtenir une solution pas trop visqueuse, pouvant être déposée par de nombreuses techniques de dépôt en voie liquide et d'avoir suffisamment de matière dans la cavité. Avec de tels rapports massiques, la solution est suffisamment mouillante au niveau des luminophores pour en empêcher l'agrégation, les luminophores sont bien séparés et la conversion de lumière est plus efficace.

Avantageusement, le rapport luminophores/matière sèche va de 15% à 50% massique. Il y a ainsi suffisamment de luminophores dans le matériau composite final pour réaliser la conversion lumineuse, tout en limitant la quantité de réactifs utilisés.

L'invention concerne également un procédé pour préparer un matériau composite, comprenant une matrice polymérique dans laquelle sont dispersés des luminophores, dans des cavités de taille micrométrique, le procédé comprenant les étapes successives suivantes :

- fourniture d'un substrat comprenant des cavités de tailles micrométriques,
- dépôt d'une solution telle que définie précédemment, dans les cavités, les cavités comprenant un fond, une paroi latérale et une section supérieure ouverte,
- évaporation du ou des solvants, de manière à former un matériau composite comprenant une matrice polymérique dans laquelle sont dispersées les luminophores 101.

Avantageusement, le fond des cavités est en GaN.

Avantageusement, les cavités ont une section supérieure ouverte ayant une plus grande dimension allant de $1\mu m$ à $100\mu m$, et, de préférence, allant de 1 à $20\mu m$ et une profondeur allant de 1 à $50\mu m$ et, de préférence, de 5 à $10\mu m$.

Avantageusement, le substrat comprend une structure d'émission comportant une zone active adaptée à émettre un premier rayonnement lumineux à une première longueur d'onde, les luminophores de la solution déposée dans les cavités étant adaptés à émettre un second rayonnement lumineux à une seconde longueur d'onde par conversion du premier rayonnement lumineux, la seconde longueur d'onde étant supérieure à la première longueur d'onde.

**BRÈVE DESCRIPTION DES DESSINS**

La présente invention sera mieux comprise sur la base de la description qui va suivre et des dessins en annexe sur lesquels:

- la figure 1, précédemment décrite, est une représentation schématique de différentes forces exercées sur un liquide dans un tube,
- la figure 2, précédemment décrite, est un cliché obtenu au microscope électronique à balayage de microcavités remplies avec une solution de l'art antérieur,
- la figure 3 est une représentation schématique, en coupe, d'une microcavité remplie avec une solution selon un mode de réalisation particulier de l'invention,
- la figure 4 est une représentation schématique, en coupe, d'un substrat comprenant plusieurs microcavités remplies avec une solution selon un mode de réalisation particulier de l'invention,
- la figure 5 est une représentation schématique, en coupe, d'un substrat comprenant plusieurs microcavités remplies avec une solution selon un mode de réalisation particulier de l'invention,
- la figure 6 est un cliché obtenu au microscope électronique à balayage, en électrons secondaires, de microcavités remplies avec une solution ayant un seul polymère,
- la figure 7 est un cliché obtenu au microscope électronique à balayage, en électrons secondaires, de microcavités remplies avec une solution ayant deux polymères, selon un mode de réalisation particulier de l'invention,
- la figure 8 est un cliché obtenu au microscope électronique à balayage, en électrons rétrodiffusés, de microcavités remplies avec une solution ayant un seul polymère,

- la figure 9 est un cliché obtenu au microscope électronique à balayage, en électrons rétrodiffusés, de microcavités remplies avec une solution ayant deux polymères, selon un mode de réalisation particulier de l'invention,

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et pouvant se combiner entre elles.

## EXPOSÉ DÉTAILLÉ DE MODES DE RÉALISATION PARTICULIERS

La solution, selon l'invention est destinée à remplir des cavités 10 de tailles micrométriques. La solution comprend :

- des luminophores 101,
- un tensio-actif,
- un premier polymère 102 d'un premier poids moléculaire, de faible poids moléculaire,
- un deuxième polymère 103 d'un deuxième poids moléculaire, de poids moléculaire élevé,
- un ou plusieurs solvants.

Comme représenté sur la figure 3, après évaporation du ou des solvant(s), les cavités 10 sont remplies, partiellement ou totalement, par un matériau composite 100 comprenant une matrice polymérique 102, 103 dans laquelle sont dispersés les luminophores 101, de manière homogène.

Les luminophores 101 :

Les luminophores 101 sont sous forme de particules. Par particules, on entend des éléments de taille micrométrique ou nanométrique et de forme sphérique, cylindrique, ou ovoïde.

D'une manière générale, les luminophores 101 ont une plus grande dimension inférieure à $1\,\mu m$, et de préférence inférieure à 500nm.

Les luminophores 101 peuvent être des fluorophores organiques et/ou des phosphores et/ou des quantum dots.

Selon un premier mode de réalisation avantageux, les luminophores 101 peuvent être choisis parmi les phosphores, des matériaux inorganiques luminescents, de préférence sous forme de particules. Pour les phosphores du vert au jaune, il peut s'agir de $SrSi_2O_2N_2$ :$Eu^{2+}$, $\beta$-SiAlON, $Y_3Al_5O_{12}$ :$Ce^{3+}$, YAG :Ce; pour les phosphores oranges et rouges, il peut s'agir de $SrSi_5N_8$ :$Eu^{2+}$, ou encore de nitrures tels que $(Ba,Sr)_2Si_5N_8$ : $Eu^{2+}$, $(Ca,Sr)$, $AlSiN_3$ : $Eu^{2+}$, $Sr[LiAlN_4]$ : $Eu^{2+}$, $Sr[Mg_3SiN_4]$ : $Eu^{2+}$, ou de sulfure comme $Sr_{1-x}Ca_x S$ : $Eu^{2+}$, ou encore de fluorure comme $K_2SiF_6$ :$Mn^{4+}$. Un mélange de ces phosphores peut être choisi pour remplir les cavités 10. Les phosphores ont une plus grande dimension allant de 10nm à 300nm, par exemple de l'ordre de 100nm.

Selon un deuxième mode de réalisation avantageux, les luminophores 101 peuvent être des quantum dots. Les quantum dots sont des nanocristaux semiconducteurs, également appelés boîtes quantiques. Ils peuvent émettre dans l'ultraviolet, le visible, le proche infrarouge et l'infrarouge. Certains quantum dots émettent, avantageusement, à une longueur d'onde très étroite (typiquement, la largeur à mi-hauteur du pic d'émission est de 30 nm). Les quantum dots ont une plus grande dimension allant de 2nm à 20nm, et d de préférence de 1nm à 10nm. Les quantum dots peuvent être choisis parmi ZnS, ZnSe, CdS, CdSe, CdZnSe, CdTe, PbS, InP, CuInSz, $CuGaS_2$, CuInSez, $CuGaSe_2$, $CuInGaSe_2$, CuSe, InSe, et GaSe. Un mélange de ces quantum dots peut être choisi pour remplir les cavités 10. Comme leur absorption est élevée et leur émission est forte, il est possible de les utiliser en faible quantité contrairement aux fluorophores organiques, qui ont une intensité lumineuse plus faible.

De préférence, le taux de charge des luminophores 101 dans la matière sèche après dépôt, va de 15% à 50% volumique.

Le tensio-actif :

Le tensio-actif assure la dispersion des luminophores 101 dans la solution. Le tensio-actif peut recouvrir partiellement ou totalement la surface des particules de luminophores 101. On choisira un tensio-actif qui ne modifie les propriétés optiques des luminophores.

Le tensio-actif est, de préférence, non ionique, c'est-à-dire qu'il n'est pas chargé. Il s'agit, par exemple, d'un des tensio-actifs de type TEGO®, commercialisé par la société Evonik Resource Efficiency GmbH. On choisira, par exemple, un TEGO® à base de siloxane pour avoir un dispositif présentant une grande longévité. On pourra également choisir un tensio-actif dans la gamme des Triton™ commercialisé par la société Dow Chemical Company.

Les polymères 102, 103 :

La solution comprend un premier polymère 102 d'un premier poids moléculaire et un deuxième polymère 103 d'un deuxième poids moléculaire, le deuxième poids moléculaire étant de 10 à 50 fois supérieur au premier poids moléculaire, et, de préférence, de 15 à 35 fois supérieur au premier poids moléculaire.

Par poids moléculaire, on entend le poids moléculaire moyen en nombre Mn, aussi appelé masse molaire moyenne en nombre, et correspondant à la moyenne des masses molaires pondérée par le nombre de chaînes de chaque longueur. Le poids moléculaire peut, par exemple, être déterminé par chromatographie d'exclusion avec étalons polystyrène.

Par exemple, les polymères sont issus de réaction de polymérisation radicalaire où le ratio I de polydispersité est Mw/Mn =2.

D'une manière générale, le premier poids moléculaire est d'au moins 500g/mol et d'au plus 50000g/mol, et de préférence de 10000g/mol à 25000g/mol.

D'une manière générale, le deuxième poids moléculaire est d'au moins 5000g/mol et d'au plus 2500000g/mol, et de préférence d'au moins 50000g/mol et d'au plus 1250000g/mol.

Le premier polymère 102 et le deuxième polymère 103, ayant différents poids moléculaires, et donc différentes longueurs de chaîne, servent de matrice pour maintenir mécaniquement les luminophores 101.

Le polymère de haut poids moléculaire 103 va jouer le rôle d'un agent texturant en figeant et en conservant la structure étendue ou « gonflée » des polymères. Le polymère de bas poids moléculaire va se rétracter pour adhérer sur le squelette du polymère de haut poids moléculaire. Les particules de luminophores restant piégées dans le réseau de polymères et ne migrent pas. Ceci permet de réduire ou d'annihiler le retrait de séchage.

Au moment du remplissage de la cavité par la solution, les grandes chaînes vont servir de squelette à la structure polymérique. Ces grandes chaînes vont figer la charge de luminophores et les petites chaînes de polymères, ce qui conduit à une bonne homogénéité de la solution et donc à une bonne répartition des luminophores au sein de la microcavité. Cette structuration des polymères a une incidence positive sur le contrôle du retrait du solvant : l'armature formée par les grandes chaînes va limiter et contrôler les effets de retrait associés à l'évaporation du solvant.

Avec une telle solution, il n'y a pas de déformation de l'interface air/solide lors de l'évaporation du solvant.

Pour avoir un figeage "instantané" lors du séchage, on choisira un deuxième poids moléculaire de 10 à 50 fois supérieur au premier poids moléculaire. Par exemple, on choisira un deuxième poids moléculaire 20 fois supérieur au premier poids moléculaire.

Pour choisir les polymères 102, 103, l'homme du métier prendra en compte, notamment, la stabilité de la solution et sa viscosité pour pouvoir la déposer par les techniques de dépôt couramment disponibles.

Le rapport entre longue chaînes et courtes chaînes permet de contrôler la viscosité initiale du mélange et de formuler une solution avec une viscosité compatible avec, par exemple, un procédé d'enduction. Le premier polymère 102 de faible poids moléculaire est, de préférence majoritaire, c'est-à-dire que le premier polymère 102 représente plus de 50% de la masse totale des polymères. Les solutions obtenues peuvent être déposées par de nombreuses techniques de dépôt et sont stables dans le temps, ce qui permet de les déposer de façon reproductible dans le temps.

On choisira également des polymères présentant un indice de réfraction tel qu'il ne perturbe pas l'excitation des luminophores ni l'extraction de la lumière émise.

Le choix des polymères devra donc prendre aussi en compte la capacité du système solvant(s)/polymères/tensio-actif à disperser les luminophores.

On choisira, de préférence, les polymères 102, 103, indépendamment l'un de l'autre, parmi les polyalkylmethacrylate (tel que le PMMA), les polyarylmethacrylates, les polyméthacrylates polycycliques (par exemple, de type polybornaneméthacrylate, les polyalkyl acrylates, les polyarylacrylates, les polyarylsiloxanes et polyalkylsiloxanes. On peut également choisir les polymères parmi les polycarbonates, les poly (ε- caprolactone), et les polystyrènes. Les polymères sont de préférence non substitués. Ces polymères répondent aux critères énoncés ci-dessus. Ces polymères ont, par exemple, une chaîne carbonée en C1-C10.

Les polymères 102, 103 peuvent être des homopolymères ou des copolymères des polymères précédemment cités.

On peut utiliser des polymères 102, 103 de natures chimiques différentes, par exemple du PMMA et du polystyrène.

On peut également utiliser des polymères 102, 103 de même nature chimique, c'est-à-dire de la même famille. De préférence, les deux polymères 102, 103 sont deux PMMA de poids moléculaires différents.

Le ou les solvant(s) :

Le solvant est, de préférence, organique.

Pour avoir une faible viscosité, on choisira avantageusement, une solution contenant au moins un bon solvant. La solution peut comprendre en plus un solvant intermédiaire.

Par bon solvant, on entend qu'il permet de faire gonfler les chaînes de polymère. Les interactions polymère/polymère sont défavorisées. Les polymères sont bien dispersés dans le solvant.

Par solvant intermédiaire, on entend qu'il est indifférent d'avoir des interactions polymères/polymères ou polymères/solvant.

Par mauvais solvant, on entend que les interactions polymère/polymère sont favorisées, les chaînes de polymère s'effondrent sur elles-mêmes et/ou précipitent en totalité.

Le choix du solvant peut être réalisé en utilisant les paramètres de Hansen. Les paramètres de Hansen permettent de déterminer une sphère de solubilité pour chaque type de polymère. Chaque solvant a une également ses propres paramètres de Hansen. On peut donc placer le solvant dans le même repère que la sphère du polymère étudié. Si le solvant est dans la sphère, il s'agit d'un bon solvant pour le polymère. Si le solvant est en dehors de la sphère, alors il s'agit d'un mauvais solvant du polymère. Ces paramètres permettent également de calculer les coordonnées d'un mélange de solvants.

A titre illustratif, les paramètres de Hansen du PMMA sont [17.7, 9.1, 7.1], ceux de l'anisole (aussi appelée méthoxybenzène) sont [17.8, 4.1, 6.7], et ceux de la méthyléthylcétone (aussi appelée butanone ou MEK) sont [16, 9, 5.1]. Les deux premiers sont prépondérants pour le choix du solvant. La MEK est un bon solvant du PMMA et l'anisole est un solvant intermédiaire.

Pour limiter les interactions entre les chaînes de polymère en solution, et donc garder une viscosité raisonnable, il faut également que la différence entre les poids d'ébullition des solvants soit d'au moins trente degrés Celsius et que ce soit, de préférence, le meilleur solvant qui soit le plus volatil.

Pour le PMMA, on peut donc choisir une solution contenant un bon solvant comme la MEK (point d'ébullition : 89°C) et un solvant intermédiaire comme l'anisole (point d'ébullition : 155,5°C). La MEK, le bon solvant, va s'évaporer, en premier après le dépôt. L'anisole étant un solvant intermédiaire va fixer et conserver la structure des polymères.

Il est également possible de déterminer les associations polymères/solvants en utilisant le paramètre de solubilité d'Hildebrand.

Le paramètre de solubilité pour le PMMA, la méthyléthylcétone et l'anisole sont respectivement de : 9,3 $(cal/cm^3)^{1/2}$, 9,43 $(cal/cm^3)^{1/2}$, 9,7 $(cal/cm^3)^{1/2}$. Ceci confirme les résultats obtenus avec le paramètre de Hansen : la MEK est un meilleur solvant pour le PMMA que l'anisole.

La viscosité sera déterminée en fonction de la technique de dépôt par voie humide (enduction, jet d'encre, spin coating par exemple).

On choisira une solution suffisamment mouillante pour disperser les luminophores mais pas trop mouillante pour ne pas créer des ménisques convexes dans les microcavités.

Le rapport solvant/matière sèche va, de préférence, de 40% à 60% massique.

Procédé de remplissage de cavités 10 avec des luminophores 101 :

Le procédé de remplissage de cavités 10 de tailles micrométriques avec des luminophores 101 comprend les étapes successives suivantes :

- fourniture d'un substrat comprenant des cavités 10 de tailles micrométriques,
- dépôt d'une solution telle que définie précédemment, dans les cavités 10,
- évaporation du ou des solvants, de manière à obtenir un matériau composite sec comprenant une matrice polymérique dans laquelle sont dispersées les luminophores 101.

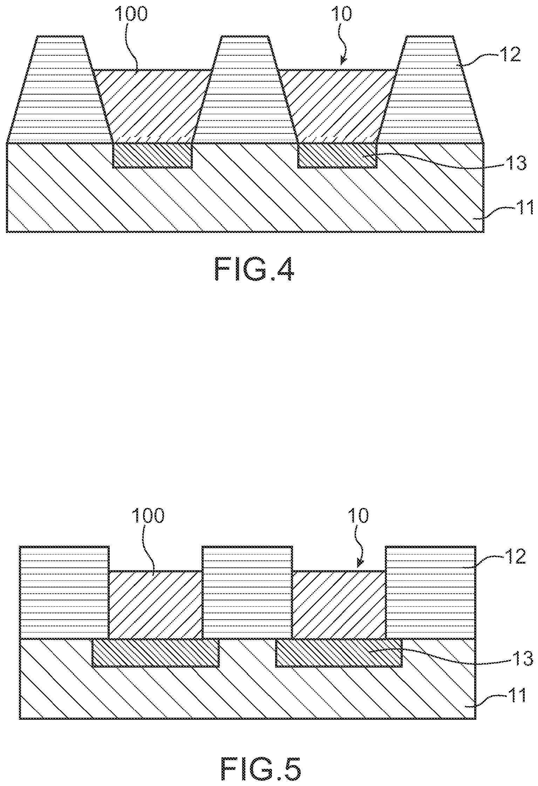

Comme représenté sur les figures 4 et 5, le substrat comporte au moins une cavité 10 à remplir. De préférence, le substrat comprend une pluralité de cavités 10. Les cavités 10 sont, par exemple, disposées en formant une matrice de plusieurs lignes et plusieurs colonnes de cavités. Le pas des cavités, dans le plan du substrat, est par exemple compris entre environ 10$\mu$m et 100$\mu$m, et de préférence entre 50$\mu$m et 100$\mu$m.

Les cavités 10 sont de taille micrométrique, c'est-à-dire qu'elles ont des dimensions allant de l'ordre du micromètre à la centaine de micromètres. On parle aussi de microcavités.

Les cavités 10 comprennent une paroi inférieure fermée 13 (ou fond), une paroi latérale 12 et une section supérieure ouverte. La paroi inférieure et la section supérieure peuvent avoir des formes identiques ou différentes, par exemple des formes circulaires, elliptiques, carrées, rectangulaires, etc. Les cavités sont, par exemple, des tubes de section carrée ou circulaire.

La hauteur de la paroi latérale 12 définit la profondeur de la cavité 10. Les cavités 10 ont une profondeur allant de quelques micromètres (par exemple, 1, 2 ou 3μm) à 50μm, et de préférence de 5μm à 10μm.

Les cavités 10 ont une section supérieure ayant une plus grande dimension allant de quelques micromètres (par exemple, 1, 2 ou 3μm) à 100μm, et de préférence de 1μm à 20μm, par exemple de l'ordre de 10μm.

Les parois 12 des cavités 10 peuvent être formées par tout matériau adapté.

Il peut s'agir d'une paroi 12 métallique, telle que du cuivre, de l'aluminium, ou d'une paroi en un oxyde métallique, par exemple de l'alumine (figure 4). Une telle paroi 12 peut être réalisée par dépôt électrochimique, éventuellement suivi d'une étape d'oxydation. La paroi 12 est, avantageusement, réfléchissante et non absorbante.

Les parois 12 peuvent être réalisées en un matériau provisoire (figure 5), c'est-à-dire qu'après l'obtention du matériau composite 100, dans les cavités 10, la paroi 12 est retirée. Il peut s'agir par exemple d'une résine. La résine pourra être retirée par voie chimique. On obtient alors une matrice de plots de matériau composite 100, séparés par de l'air.

Le fond 13 des cavités 10 est une couche qui émet de la lumière. Il s'agit, par exemple, d'une couche de GaN.

Les cavités 10 peuvent être réalisées sur un support 11, par exemple en CdSe ou en InGaN, ou en un bicouche InGaN/GaN.

De préférence, le substrat comprend une structure d'émission comportant une zone active adaptée à émettre un premier rayonnement lumineux à une première longueur d'onde $\lambda_1$, les luminophores 101 de la solution déposée dans les cavités 10 étant adaptés à émettre un second rayonnement lumineux à une seconde longueur d'onde $\lambda_2$ par conversion du premier rayonnement lumineux, la seconde longueur d'onde $\lambda_2$ étant telle que $\lambda_1 < \lambda_2$.

La solution peut être déposée par toute technique de dispense en voie liquide. A titre illustratif, il peut s'agir d'un dépôt par jet d'encre, par pulvérisation, par trempage, par enduction (avec raclage « doctor blade », ou par dépôt à la tournette «spin coating »), ou par impression 3D.

Pour des couches de conversion comprenant des quantum dots, on pourra avoir un matériau composite 100 ayant une épaisseur allant, par exemple, de 5 à 10μm. Les quantum dots présentent une bonne absorption. Une faible quantité est suffisante.

Pour des couches de conversion comprenant des phosphores, on pourra avoir un matériau composite 100 ayant une épaisseur allant, par exemple, de 50μm à 100μm.

Exemples illustratifs et non limitatifs de modes de réalisation :

Le tableau suivant présente différentes solutions. Les solutions S19, S20, S25 et S26 sont des solutions selon l'invention, et comprennent deux PMMA de poids moléculaires différents. Les solutions S17, S18, S23 et S24 ont été réalisées à titre de comparaison et contiennent un seul PMMA. Le tensioactif est du TEGO® Dispers 670, commercialisé par la société Evonik Resource Efficiency GmbH.

| | S17 | S19 | S18 | S20 | S23 | S25 | S24 | S26 |
|---|---|---|---|---|---|---|---|---|
| **PMMA** | 8,4% | 8,4% | 15,2% | 15,2% | 8,4% | | 17,5% | |
| | 15000 g/mol | 5,9% de 15000 g/mol | 15000 g/mol | 13,7% de 15000 g/mol | 15000 g/mol | 5,9% de 15000 g/mol | 15000 g/mol | 15,6% de 15000 g/mol |
| | | 2,5% de 350 000 g/mol | | 1,5% de 350 000 g/mol | | 2,5% de 350 000 g/mol | | 1,4% de 350 000 g/mol |
| **Anisole** | 59% | | 45,7% | | 62% | | 52,9% | |
| **YAG :Ce** | 3,5% | | 26,8% | | 3,6% | | 3,6% | |
| **MEK** | 23,3% | | 6% | | 24,3% | | 24,3% | |
| **Tensioactif** | 5,8% | | 6,3% | | 1,7% | | 1,7% | |

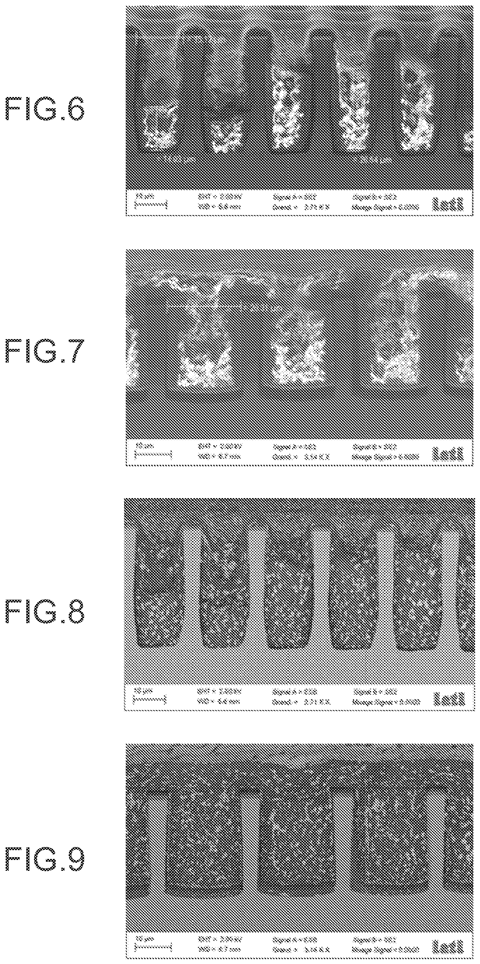

Ces solutions ont ensuite été déposées sur des substrats ayant des microcavités par une technique d'enduction. Les parois des cavités sont recouvertes par une couche d'aluminium. Les cavités remplies avec les solutions ont été observées au microscope électronique à balayage en mode électrons secondaires (figures 6 et 7) et en mode électrons rétrodiffusés (figures 8 et 9).

Les cavités remplies avec les solutions selon l'invention (figures 7 et 9) présentent une répartition homogène des luminophores sur toute la hauteur de la cavité, ce qui n'est pas le cas des solutions comparatives (figures 6 et 8).

**Revendications**

1. Solution, destinée à être utilisée pour remplir des cavités (10) de taille micrométrique, la solution comprenant un premier solvant, un premier polymère (102) d'un premier poids moléculaire, un deuxième polymère (103) d'un deuxième poids moléculaire, des luminophores (101), et un tensio-actif, le deuxième poids moléculaire étant de 10 à 50 fois supérieur au premier poids moléculaire.

2. Solution selon la revendication 1, **caractérisée en ce que** le premier poids moléculaire est environ 20 fois supérieur au deuxième poids moléculaire.

3. Solution selon l'une des revendications 1 et 2, **caractérisée en ce que** le premier polymère (102) et le deuxième polymère (103) sont choisis indépendamment l'un de l'autre parmi un poly(méth)acrylate, un polysiloxane, un polycarbonate, un poly($\varepsilon$-caprolactone), un polystyrène et un de leur copolymère.

4. Solution selon l'une quelconque des revendications précédentes, **caractérisée en ce que** le premier polymère (102) et/ou le deuxième polymère (103) sont des homopolymères.

5. Solution selon l'une quelconque des revendications précédentes, **caractérisée en ce que** le premier polymère (102) et le deuxième polymère (103) sont des poly(méthacrylate de méthyle).

6. Solution selon l'une quelconque des revendications précédentes, **caractérisée en ce que** la solution comporte un deuxième solvant, dont la température d'ébullition est supérieure d'au moins 30°C à la température d'ébullition du premier solvant.

7. Solution selon la revendication 6, **caractérisée en ce que** le premier solvant est la butanone et **en ce que** le deuxième solvant est l'anisole.

8. Solution selon l'une quelconque des revendications précédentes, **caractérisée en ce que** les luminophores (101) sont choisis parmi les phosphores, tels que $SrSi_2O_2N_2$ :$Eu^{2+}$, $\beta$-SiAlON, $Y_3Al_5O_{12}$ :$Ce^{3+}$, $SrSi_5N_8$ :$Eu^{2+}$, $(Ba,Sr)_2Si_5N_8$ : $Eu^{2+}$, $(Ca,Sr)AlSiN_3$ :$Eu^{2+}$ $Sr[LiAlN_4]$ : $Eu^{2+}$, $Sr[Mg_3SiN_4]$ : $Eu^{2+}$, $Sr_{1-x}$ $Ca_x$ S : $Eu^{2+}$, $K_2SiF_6$ :$Mn^{4+}$, et parmi les quantum dots tels que ZnS, ZnSe, CdS, CdSe, CdZnSe, CdTe, PbS, InP, $CuInS_2$, $CuGaS_2$, $CuInSe_2$, $CuGaSe_2$, $CuInGaSe_2$, CuSe, InSe, et GaSe.

9. Solution selon l'une quelconque des revendications précédentes, **caractérisée en ce que** les luminophores (101) ont une plus grande dimension inférieure à 1$\mu$m, et de préférence inférieure à 500nm.

10. Solution selon l'une quelconque des revendications précédentes, **caractérisée en ce que** le rapport solvant/matière sèche va de 40% à 60% massique.

11. Solution selon l'une quelconque des revendications précédentes, **caractérisée en ce que** le rapport luminophores (101)/matière sèche va de 15% à 50% massique.

12. Procédé pour préparer un matériau composite, comprenant une matrice polymérique dans laquelle sont dispersés des luminophores, dans des cavités de taille micrométrique, le procédé comprenant les étapes successives suivantes :

    - fourniture d'un substrat comprenant des cavités (10) de tailles micrométriques, les cavités comprenant un fond (13), une paroi latérale (12) et une section supérieure ouverte,
    - dépôt d'une solution telle que définie dans l'une quelconque des revendications 1 à 12, dans les cavités (10),
    - évaporation du ou des solvants, de manière à former un matériau composite (100) comprenant une matrice polymérique dans laquelle sont dispersées les luminophores (101).

13. Procédé selon la revendication précédente, **caractérisé en ce que** le fond (13) des cavités (10) est en GaN.

14. Procédé selon l'une des revendications 12 et 13, **caractérisé en ce que** les cavités (10) ont une section supérieure ouverte ayant une plus grande dimension allant de 1$\mu$m à 100$\mu$m, et de préférence allant de 1 à 20$\mu$m et une profondeur allant de 1 à 50$\mu$m et de préférence de 5 à 10$\mu$m.

15. Procédé selon l'une quelconque des revendications 12 à 14, **caractérisé en ce que** le substrat comprend une structure d'émission comportant une zone active adaptée à émettre un premier rayonnement lumineux à une première longueur d'onde ($\lambda_1$), les luminophores (101) de la solution déposée dans les cavités (10) étant adaptés à émettre un second rayonnement lumineux à une seconde longueur d'onde ($\lambda_2$) par conversion du premier rayonnement lumineux, la seconde longueur d'onde ($\lambda_2$) étant supérieure à la première longueur d'onde ($\lambda_1$).

**Patentansprüche**

1. Lösung, bestimmt zur Verwendung beim Füllen von Hohlräumen (10) mit Mikrometergröße, wobei die Lösung ein erstes Lösungsmittel, ein erstes Polymer (102) mit einem ersten Molekulargewicht, ein zweites Polymer (103) mit einem zweiten Molekulargewicht, Luminophore (101) und ein Tensid umfasst, wobei das zweite Molekulargewicht 10 bis 50 Mal größer ist als das erste Molekulargewicht.

2. Lösung nach Anspruch 1, **dadurch gekennzeichnet, dass** das erste Molekulargewicht etwa 20 Mal größer ist als das zweite Molekulargewicht.

3. Lösung nach einem der Ansprüche 1 oder 2, **dadurch gekennzeichnet, dass** das erste Polymer (102) und das zweite Polymer (103) unabhängig voneinander ausgewählt sind aus einem Poly(meth)acrylat, einem Polysiloxan, einem Polycarbonat, einem Poly($\epsilon$-caprolacton), einem Polystyrol und einem ihrer Copolymere.

4. Lösung nach einem der vorhergehenden Ansprüche, **dadurch gekennzeichnet, dass** das erste Polymer (102) und/oder das zweite Polymer (103) Homopolymere sind.

5. Lösung nach einem der vorhergehenden Ansprüche, **dadurch gekennzeichnet, dass** das erste Polymer (102) und das zweite Polymer (103) Poly(methylmethacrylat) sind.

6. Lösung nach einem der vorhergehenden Ansprüche, **dadurch gekennzeichnet, dass** die Lösung ein zweites Lösungsmittel umfasst, dessen Siedetemperatur um mindestens 30°C höher ist als die Siedetemperatur des ersten Lösungsmittels.

7. Lösung nach Anspruch 6, **dadurch gekennzeichnet, dass** das erste Lösungsmittel Butanon ist und dass das zweite Lösungsmittel Anisol ist.

8. Lösung nach einem der vorhergehenden Ansprüche, **dadurch gekennzeichnet, dass** die Luminophore (101) ausgewählt sind aus Phosphoren wie $SrSi_2O_2N_2 :Eu^{2+}$, $\beta$-SiAlON, $Y_3Al_5O_{12} :Ce^{3+}$, $SrSi_5N_8 :Eu^{2+}$, $(Ba,Sr)_2Si_5N_8 : Eu^{2+}$, $(Ca,Sr)AlSiN_3 :Eu^{2+}$, $Sr[LiAlN_4] :Eu^{2+}$, $Sr[Mg_3SiN_4] :Eu^{2+}$, $Sr_{1-x}Ca_xS :Eu^{2+}$, $K_2SiF_6 :Mn^{4+}$, und aus Quantum Dots wie ZnS, ZnSe, CdS, CdSe, CdZnSe, CdTe, PbS, InP, $CuInS_2$, $CuGaS_2$, $CuInSe_2$, $CuGaSe_2$, $CuInGaSe_2$, CuSe, InSe und GaSe.

9. Lösung nach einem der vorhergehenden Ansprüche, **dadurch gekennzeichnet, dass** die Luminophore (101) eine größte Abmessung von weniger als 1 $\mu$m und vorzugsweise weniger als 500 nm aufweisen.

10. Lösung nach einem der vorhergehenden Ansprüche, **dadurch gekennzeichnet, dass** das Verhältnis von Lösungsmittel zu Trockenmasse 40 % bis 60 % Masse beträgt.

11. Lösung nach einem der vorhergehenden Ansprüche, **dadurch gekennzeichnet, dass** das Verhältnis von Luminophoren (101) zu Trockenmasse 15 % bis 50 % Masse beträgt.

12. Verfahren zum Herstellen eines Verbundmaterials, das eine Polymermatrix umfasst, in der Luminophoren in mikrometergroßen Hohlräumen dispergiert sind, wobei das Verfahren die folgenden aufeinanderfolgenden Schritte umfasst:

   - Bereitstellen eines Substrats mit mikrometergroßen Hohlräumen (10), wobei die Hohlräume einen Boden (13), eine Seitenwand (12) und einen offenen oberen Abschnitt umfassen,
   - Ablagerung einer Lösung, wie sie in einem der Ansprüche 1 bis 12 definiert ist, in den Hohlräumen (10),
   - Verdampfung des oder der Lösungsmittel, um ein Verbundmaterial (100) zu bilden, das eine Polymermatrix umfasst, in der die Luminophore (101) dispergiert sind.

**13.** Verfahren nach dem vorhergehenden Anspruch, **dadurch gekennzeichnet, dass** der Boden (13) der Hohlräume (10) aus GaN besteht.

**14.** Verfahren nach einem der Ansprüche 12 und 13, **dadurch gekennzeichnet, dass** die Hohlräume (10) einen offenen oberen Abschnitt aufweisen, der eine größere obere Abmessung aufweist, die von 1 $\mu$m bis 100 $\mu$m, vorzugsweise von 1 bis 20 $\mu$m reicht und eine Tiefe, die von 1 bis 50 $\mu$m und vorzugsweise von 5 bis 10 $\mu$m reicht.

**15.** Verfahren nach einem der Ansprüche 12 bis 14, **dadurch gekennzeichnet, dass** das Substrat eine Emissionsstruktur umfasst, die einen aktiven Bereich enthält, der darauf ausgerichtet ist, eine erste Lichstrahlung mit einer ersten Wellenlänge ($\lambda_1$) auszusenden, wobei die Luminophore (101) der Lösung, die in den Hohlräumen (10) abgelagert sind, darauf ausgerichtet sind, eine zweite Lichstrahlung mit einer zweiten Wellenlänge ($\lambda_2$) durch Konversion der ersten Lichstrahlung auszusenden, wobei die zweite Wellenlänge ($\lambda_2$) größer ist als die erste Wellenlänge ($\lambda_1$).

**Claims**

**1.** Solution for use in filling micrometer-size cavities (10), the solution comprising a first solvent, a first polymer (102) having a first molecular weight, a second polymer (103) having a second molecular weight, luminophores (101) and a surfactant, the second molecular weight being 10 to 50 times greater than the first molecular weight.

**2.** Solution according to claim 1, **characterised in that** the first molecular weight is approximately 20 times greater than the second molecular weight.

**3.** Solution according to one of claims 1 and 2, **characterised in that** the first polymer (102) and the second polymer (103) are chosen independently of each other among a poly(meth)acrylate, a polysiloxane, a polycarbonate, a poly($\varepsilon$-caprolactone), a polystyrene and one of the copolymers thereof.

**4.** Solution according to any one of the preceding claims, **characterised in that** the first polymer (102) and/or the second polymer (103) are homopolymers.

**5.** Solution according to any one of the preceding claims, **characterised in that** the first polymer (102) and the second polymer (103) are poly(methyl methacrylate).

**6.** Solution according to any one of the preceding claims, **characterised in that** the solution comprises a second solvent, the boiling point of which is at least 30°C higher than the temperature of the first solvent.

**7.** Solution according to claim 6, **characterised in that** the first solvent is butanone and **in that** the second solvent is anisole.

**8.** Solution according to any one of the preceding claims, **characterised in that** the luminophores (101) are chosen among the phosphors, such as $SrSi_2O_2N_2:Eu^{2+}$, $\beta$-SiAlON, $Y_3Al_5O_{12}:Ce^{3+}$, $SrSi_5N_8:Eu^{2+}$, $(Ba,Sr)_2Si_5N_8:Eu^{2+}$, $(Ca,Sr)AlSiN_3:Eu^{2+}$, $Sr[LiAlN_4]:Eu^{2+}$, $Sr[Mg_3SiN_4]:Eu^{2+}$, $Sr_{1-x}Ca_xS:Eu^{2+}$, $K_2SiF_6:Mn^{4+}$, and among the quantum dots such as ZnS, ZnSe, CdS, CdSe, CdZnSe, CdTe, PbS, InP, $CuInS_2$, $CuGaS_2$, $CuInSe_2$, $CuGaSe_2$, $CuInGaSe_2$, CuSe, InSe, and GaSe.

**9.** Solution according to any one of the preceding claims, **characterised in that** the luminophores (101) have a largest dimension less than 1 $\mu$m, and preferably less than 500 nm.

**10.** Solution according to any one of the preceding claims, **characterised in that** the ratio solvent/dry matter is in the range from 40% to 60% by mass.

**11.** Solution according to any one of the preceding claims, **characterised in that** the ratio luminophores (101)/dry matter is in the range from 15% to 50% by mass.

**12.** Method for preparing a composite material, comprising a polymer matrix in which luminophores are dispersed, in micrometer-size cavities, the method comprising the following consecutive steps:

- providing a substrate comprising micrometer-size cavities (10), the cavities comprising a bottom (13), a side wall (12) and an open upper section,
- depositing a solution, such as defined in any one of claims 1 to 12, in the cavities (10),
- evaporating the solvent or solvents, so as to form a composite material (100) comprising a polymer matrix in which the luminophores (101) are dispersed.

**13.** A method according to the preceding claim, **characterised in that** the bottom (13) of the cavities (10) is made of GaN.

**14.** A method according to one of claims 12 and 13, **characterised in that** the cavities (10) have an open upper section having a largest dimension in the range from 1 $\mu$m to 100 $\mu$m, and preferably in the range from 1 to 20 $\mu$m, and a depth in the range from 1 to 50 $\mu$m and preferably from 5 to 10 $\mu$m.

**15.** Method according to any one of claims 12 to 14, **characterised in that** the substrate comprises an emission structure having an active zone suitable for emitting a first visible radiation at a first wavelength ($\lambda_1$), the luminophores (101) of the solution deposited in the cavities (10) being suitable for emitting a second visible radiation at a second wavelength ($\lambda_2$) by conversion of the first visible radiation, the second wavelength ($\lambda_2$) being greater than the first wavelength ($\lambda_1$).

FIG.1

FIG.2

FIG.3

FIG.4

FIG.5

**FIG.6**

**FIG.7**

**FIG.8**

**FIG.9**

**EP 3 720 923 B1**

## RÉFÉRENCES CITÉES DANS LA DESCRIPTION

**Documents brevets cités dans la description**

- WO 2017180333 A1
- EP 2826836 A1
- US 2017306221 A1